# EUROPEAN PATENT SPECIFICATION

(11) **EP 0 628 409 B1**
(45) Date of publication and mention of the grant of the patent: **10.09.1997**
(21) Application number: 93201686.8
(22) Date of filing: 11.06.1993
(51) Int. Cl.: B41C 1/055, B41N 3/03, B41M 5/24, B41N 1/08, G03F 7/07

(54) **Heat mode recording and method for making a printing plate therewith**
Wärmeaufzeichnungsverfahren und Verfahren zur Herstellung von Druckplatten damit
Procédé pour l'enregistrement par la chaleur et procédé pour la fabrication de plaques d'impression utilisant ce procédé

(43) Date of publication of application: 14.12.1994
(73) Proprietor: AGFA-GEVAERT naamloze vennootschap, 2640 Mortsel (BE)
(72) Inventor: Verburgh, Yves, c/o Agfa-Gevaert N.V., DIE 3800, B- 2640 Mortsel (BE); Dewanckele, Jean-Marie c/o Agfa- Gevaert N.V.,, B- 2640 Mortsel (BE); Heugebaert, Franciscus c/o Agfa- Gevaert N.V.,, B- 2640 Mortsel (BE); Leenders, Luc c/o Agfa- Gevaert N.V., DIE 3800,, B- 2640 Mortsel (BE)

(56) References cited:
- EP-A- 0 030 642
- EP-A- 0 036 469
- EP-A- 0 101 266
- WO-A-83/02505
- FR-A- 1 092 609
- FR-A- 2 287 715
- GB-A- 1 246 696
- GB-A- 2 081 183
- NL-C- 57 602
- US-A- 3 085 008
- US-A- 3 639 124
- US-A- 3 690 883
- IBM TECHNICAL DISCLOSURE BULLETIN. vol. 32, no. 8B , January 1990 , NEW YORK US page 465 AN. 'Passivation of the aluminum film of negative-direct plate'

## Description

### 1. Field of the invention.

The present invention relates to a heat mode recording material for making a lithographic printing plate for use in lithographic printing. The present invention further relates to a method for imaging said heat mode recording material by means of a laser.

### 2. Background of the invention.

Lithographic printing is the process of printing from specially prepared surfaces, some areas of which are capable of accepting ink (oleophilic areas) whereas other areas will not accept ink (oleophobic areas). The oleophilic areas form the printing areas while the oleophobic areas form the background areas.

Wet printing plates can be prepared using a photographic material that is image wise receptive or repellant to ink upon photoexposure of the photographic material. However heat mode recording materials, the surface of which can be made image-wise receptive or repellant to ink upon image-wise exposure to heat and/or subsequent development are also known for preparing wet printing plates.

Particular interesting heat mode recording materials for printing plate applications are those comprising on a support a thin metal layer sensitive to hydrophobic-hydrophilic mapping of an image by laser irradiation.

For example Japanese patent application laid open to public inspection no. 52-37104 discloses an offset printing plate comprising on a support (for example on aluminium, a polyester film, R.C. paper etc.) (i) an anodically produced, porous aluminiumoxide layer having a thickness of more than 0.5 nm and (ii) a layer containing cupper, silver, brass or graphite. The surface of the plate is exposed to a laser beam of high energy density to render the exposed areas hydrophilic. An offset printing plate is thus obtained. The disclosed heat mode recoding material is of low sensitivity as revealed by the hich laser energy, about 1 W, and rather slow writing speed of about 2 m/s.

The US-A-5 401 611 assigned to the present applicant and filed on 5.2.93 discloses a heat mode material of high sensitivity, comprising on a support, having a hydrophilic surface or provided with a hydrophilic layer, a metallic layer and on top thereof a hydrophobic layer having a thickness of less than 50 nm. The surface of the plate, e.g. a hydrophobized silver layer, is exposed to a laser beam rendering the exposed image areas hydrophilic and repellant to greasy ink.

FR-A-1,092,609 discloses a material for lithography comprising a support, a thin aluminium layer and a hydrophilic aluminum oxide layer with a thickness not larger than the diameter of one or a very few molecules.

GB-A-2,081,183 discloses a material comprising a support, a silver image obtained by diffusion transfer and a hydrophilic layer formed by treatment with a hydrophilising agent having a mercapto group and a hydrophilic group in the same molecule.

FR-A-2,287,715 discloses the use of organic and/or inorganic hydrophilic coatings which upon exposure to laser rays become oleophilic and ink-accepting without the need for further treatment

A disadvantage of these disclosed heat mode recording printing plates is the fact that they are generally positive working i.e. a hydrophobic and/or hydrophobized metallic layer is rendered hydrophilic by laser exposure. E.g. a lithographic printing plate in which a silver image forms the ink accepting areas, hereinafter called silver based printing plate, may be prepared in a heat mode recording process wherein a hydrophobized silver layer is ablated or rendered ink repellant at areas exposed with a high intensity laser beam. Such method requires that all non-image areas are exposed so that they will not accept ink in a printing process, which involves the release of high amounts of ablated material.

US-A-3,314,073 discloses that thin films of silver are not suitable as compounds for converting light into heat since they reflect most of the light.

FR-A-1,561,957 discloses that finely divided silver can indeed be used as a substance capable of converting light into heat.

From the above it is clear that a need exists for heat mode recording materials based on initially hydrophilic and/or hydrophilised metallic, e.g. silver, surfaces which can be rendered oleophilic by image-wise laser exposure.

### 3. Summary of the invention.

It is an object of the present invention to provide an alternative heat mode recording material of high sensitivity and a method for making a lithographic printing plate of high quality therewith.

Further objects of the invention will become clear from the description hereinafter.

According to the present invention there is provided a heat mode recording material comprising on a support a metallic layer and on top thereof a hydrophilic layer having a thickness of less than 50 nm, characterized in that said metallic layer is a silver layer resulting from a silver halide photographic material according to the silver salt diffusion transfer process.

According to the present invention there is provided a method for making a lithographic printing plate comprising image-wise exposing to actinic radiation a heat mode recording material comprising on a support a metallic layer and on top thereof a hydrophilic layer having a thickness of less than 50 nm wherein said metallic layer is a silver layer resulting from a silver halide photographic material according to the silver salt diffusion transfer process thereby rendering the exposed areas hydrophobic and acceptant to greasy ink.

### 4. Detailed description.

It has been found that with the above described heat mode recording material and method of the present invention printing plates can be obtained yielding a high printing endurance, high sharpness, and having a high sensivity.

Silver layers suitable for use in accordance with the present invention convert the actinic radiation to heat so that the hydrophilicity of the hydrophilic top-layer is destroyed. The thickness of the silver layer is preferably from 0,01 µm to 2 µm, most preferably from 0,05 to 1,5 µm.

The silver surfaces are those prepared from a silver halide photographic material according to the silver salt diffusion transfer process. The principles of the silver complex diffusion transfer reversal process, hereinafter called DTR-process, have been described e.g.
in US-P 2,352,014 and in the book "Photographic Silver Halide Diffusion Processes" by André Rott and Edith Wide - The Focal Press - London and New York, (1972).

In the DTR-process non-developed silver halide in a photographic silver halide emulsion layer material is transformed with a so-called silver halide solvent into soluble silver complex compounds which are allowed to diffuse into an image-receiving layer and are reduced therein with a developing agent, generally in the presence of physical development nuclei, to form a silver layer.

The silver layer can be provided on support according to the following embodiments.

According to a first embodiment the silver halide emulsion layer is provided on a support of a first element. On the support of a second element is provided a physical development nuclei layer. The first element having the silver halide emulsion layer and second element are developed in the presence of developing agent(s) and silver halide solvents(s) using an alkaline processing liquid while being in contact with each other. When both elements are subsequently peeled apart, a metallic silver layer is obtained on the second element.

According to a second embodiment the support of an element provided with a physical development nuclei layer can be provided on top thereof with the silver halide emulsion layer. Such element can then be developed in the presence of developing agent(s) and silver halide solvent(s) using an alkaline developing liquid. Subsequent to said development the element is washed with preferably warm water of about 30°C to 45°C to remove the now useless emulsion layer and to expose the metallic silver layer formed in the layer containing physical development nuclei.

According to a third embodiment a support of an element may first be provided with a silver halide emulsion layer on which is then provided a layer containing physical development nuclei. After development in the presence of silver halide solvent(s) and development agent(s) using an alkaline development liquid a metallic silver layer will be formed on top of the emulsion layer.

The hydrophilic layer provided on top of the silver layer of the heat mode recording material in connection with the present invention is preferably a monolayer of a hydrophilizing agent. Thus the thickness of the hydrophilic layer will generally be about equal to the size of a hydrophilizing agent. The hydrophilic layer may also consist of multiple layers of a hydrophilizing agent provided the total thickness remains less than 50 nm preferably less than 10 nm. As a consequence a high sensitive heat mode recording material is obtained.

The hydrophilic layer may be provided on the silver layer by simply wiping the silver layer with a solution of a hydrophilizing agent or by dipping the material to be treated in a solution of a hydrophilizing agent. The hydrophilizing treatment may also proceed automatically by conducting the element carrying a silver layer through a device having a narrow channel filled with a solution of a hydrophilizing agent and conveying the material at the end of the channel between two squeezing rollers removing the excess of liquid. Suitable devices for automatic treatment with a hydrophilizing solution are the CRF 45 and CRF 85 fixing units, both marketed by AGFA-GEVAERT, Belgium.

The hydrophilic layer may be obtained during the formation of the silver layer according to the DTR process. In the latter case the hydrophilizing agent(s) are contained in the alkaline processing liquid.

Suitable hydrophilizing compounds for use in connection with the present invention are compounds having a group capable of adsorbing to the silver layer either chemically or physically and having one or more hydrophilic groups that render the overall compound hydrophilic or repellant towards greasy ink.

According to a preferred embodiment such group capable of adsorbing to silver, is a mercapto group or the tautomeric thione group thereof. Preferred hydrophilic groups are groups that improve the aqueous solubility of the compound, typical examples of suitable hydrophilic groups are e.g. hydroxy groups, amino groups, acid groups e.g. carboxylic groups, sulphonic acid groups, sulphuric acid groups, phosphonic or phosphoric acid groups, ammonium groups, sulphonium groups etc...

Particularly suitable hydrophilizing agents that can be used in connection with the present invention are compounds according to following formula (I) :

MS-R-A (I)

wherein
M represents hydrogen, a metal cation e.g. Na+, K+ etc... or NH4+;
R represents a divalent linking group and
A represents a hydrophilic group e.g. as listed above.

It will be clear to someone skilled in the art that the hydrophilizing compounds, in particular those according to formula (I), may be present in the form of a precursor compound that upon application to the silver areas yields the hydrophilizing compound. For example, the hydrophilizing compounds according to formula (I) may be present in the hydrophilizing liquid as a disulphide. Upon application to the silver areas the sulphide bond will split so that a compound according to formula (I) is formed.

Examples of suitable divalent linking groups R in formula (I) are e.g. an unsubstituted lower alkylene (C1-C4), an unsubstituted phenylene, an oxyalkylene, a polyoxyalkylene, an alkylene substituted with one or more hydrophilic groups, an arylene substituted with one or more hydrophilic groups, an arylenealkylene substituted with one or more hydrophilic groups, an alkylenearylene substituted with one ore more hydrophilic groups, a substituted or unsubstituted heterocyclic ring etc...

Examples of hydrophilizing compounds for use in accordance with the present invention are:
4-mercaptobutylsulphonic acid and salts thereof
3-mercaptopropylsulphonic acid and salts thereof
4-mercaptobutylcarbonic acid and salts thereof
3-mercapto-5-sulphomethyl-1,2,4-triazole and salts thereof
2-mercapto-5-sulphobenzimidazole and salts thereof
2-mercapto-5-sulphobenzthiazole and salts thereof
2-mercaptomethyl-5-sulphobenzimidazole and salts thereof

The hydrophilizing liquid may contain additional ingredients such as for example hydrophilic polymers, preservative ingredients, wetting agents etc...

To obtain a lithographic plate according to the method of the present invention the heat mode recording material is image-wise exposed preferably using a laser. Preferably used lasers are e.g. semiconductor lasers, YAG lasers e.g. Nd-YAG lasers, Nd-YLF lasers, Argon lasers etc.. The laser may have a power output between 40 and 7500mW and preferably operates in the infrared part of the spectrum.

As the consequence of the image-wise exposure of the heat mode recording material, the surface of the heat mode material is selectively rendered hydrophobic and acceptant to greasy ink, whereas the non exposed areas will remain hydrophilic and ink repellant towards greasy ink. Thus no additional development step is necessary.

The image-wise exposure may also be carried out while the plate is mounted on the offset press. Such offset press, of course then includes a suitable imaging means such as e.g. a laser.

To avoid possible contamination of the environment with metal that may be partially ablated together with the thin hydrophilic layer it is advantageous to cover the thin hydrophilic layer with a hydrophilic polymer that subsequent to the imaging process can easily be dissolved so that the imaged surface can be exposed. For this purpose there can be used e.g. polyvinyl alcohol, arabic gum, polyalkylene oxides such as e.g. polyethylene oxide etc...

The present invention is illustrated by way of the following example without however the intention to limit the invention thereto. All parts are by weight unless otherwise specified.

### EXAMPLE 1

### Preparation of the silver halide emulsion coating solution.

A silver chlorobromide emulsion composed of 98.2 mole% of chloride and 1.8 mole% of bromide was prepared by the double jet precipitation method. The average silver halide grain size was 0.4 µm (diameter of a sphere with equivalent volume) and contained Rhodium as internal dopant. A base layer coating solution was prepared having the following composition :

| | |
|---|---|
| gelatin | 5.5% |
| carbon black | 0.76% |
| silica particles (5µm) | 1.6% |

### Preparation of the heat mode recording material:

The emulsion coating solution and base layer coating solution were simultaneously coated by means of the cascade coating technique to a polyethylene terephthalate support. The emulsion layer was coated such that the silver halide coverage expressed as AgNO3 was 1.5 g/m2 and the gelatin content was 1.5 g/m2. The emulsion layer further contained 0.15 g/m2 of 1-phenyl-4,4'-dimethyl-3-pyrazolidone and 0.25 g/m2 of hydroquinone. The base layer was coated such that the amount of gelatin in the coated layer was 3 g/m2.

The thus obtained element was dried and subjected to a temperature of 40 °C for 5 days and then the emulsion layer was overcoated with a layer containing PdS as physical development nuclei, hydroquinone at 0.4 g/m2 and formaldehyde at 100 mg/m2.

### Activator :

| | |
|---|---|
| sodium hydroxide (g) | 30 |
| sodium sulphite anh. (g) | 33 |
| potassium thiocyanate (g) | 20 |
| water to make | 1L |

### Dampening solution :

| | |
|---|---|
| water | 880 ml |
| citric acid | 6 g |
| boric acid | 8.4 g |
| sodium sulphate anh. | 25 g |
| ethyleneglycol | 100 g |
| colloidal silica | 28g |

The above described element was processed with the above described activator and dried.

The element was treated with an aqueous hydrophilizing solution of 0.1 % of guanidinium salt of 4-mercapto-n.butylsulphonic acid.

A heat mode recording material according to the invention is thus obtained. This material was image-wise exposed using a Nd-YLF laser (1053 nm) at a linear writing speed of 32.8 m/s, with a spot diameter of 18 µm (1/e2) and a power output of 1600 mW at plate level.

The printing plate thus prepared was likewise mounted on an offset printing machine (Heidelberg GTO-52) and was used to print with a commonly employed ink and the above described dampening solution.

Negative print copies were obtained i.e. the laser image-wise exposed areas were printed while the background (non-exposed) areas were not printed.

### EXAMPLE 2

An unexposed DTR material having a roughened and anodized aluminium support was prepared as described in EP-A-410500 according to the silver salt diffusion transfer process. The thus obtained silver based heat mode material was treated with an aqueous hydrophilizing solution of 0.1 % of guanidinium salt of 4-mercapto-n.butylsulphonic acid.

After drying in the air for 1 hour, the heat mode recording material according to the invention was image-wise exposed using a Nd-YLF laser laser (1053 nm) at a linear writing speed of 32.8 m/s, with a spot diameter of 18 µm (1/e2) and a power output of 1600 mW at plate level.

The printing plate thus obtained was mounted on an offset printing machine (Heidelberg GTO-52) and was used to print with a commonly employed ink and fountain solution.

Negative print copies were obtained i.e. the laser image-wise exposed areas were printed while the background (non-exposed) areas were not printed.

## Claims

1. A heat mode recording material comprising on a support a metallic layer and on top thereof a hydrophilic layer having a thickness of less than 50 nm, characterized in that said metallic layer is a silver layer resulting from a silver halide photographic material according to the silver salt diffusion transfer process.

2. A heat mode recording material according to claim 1 wherein the thickness of said metallic layer is between 0.05 µm and 1.5 µm.

3. A heat mode recording material according to claim 1 wherein said hydrophilic layer on said metallic layer contains a hydrophilizing agent corresponding to following formula :
MS-R-A
wherein
M represents hydrogen, a metal cation or NH4+;
R represents a divalent linking group and
A represents a hydrophilic group

4. A heat mode recording material according to claim 3 wherein said divalent linking group is an unsubstituted lower alkylene (C1-C4), an unsubstituted phenylene, an oxyalkylene, a polyoxyalkylene, an alkylene substituted with one or more hydrophilic groups, an arylene substituted with one or more hydrophilic groups, an arylenealkylene substituted with one or more hydrophilic groups, an alkylenearylene substituted with one or more hydrophilic groups or a substituted or unsubstituted heterocyclic ring.

5. A heat mode recording material according to any of the above claims further comprising on top of said hydrophilic layer having a thickness of less than 50nm a hydrophilic polymer layer.

6. A method for making a lithographic printing plate comprising image-wise exposing to actinic radiation a heat mode recording material as defined in any of the above claims thereby rendering the exposed areas oleophilic and acceptant to greasy ink.

7. A method according to claim 6 wherein said image-wise exposure is carried out by a laser.

## Patentansprüche

1. Ein wärmeempfindliches Aufzeichnungsmaterial, das auf einem Träger eine Metallschicht und eine darauf befindliche hydrophile Schicht mit einer Stärke von nicht mehr als 50 nm enthält, dadurch gekennzeichnet, daß die Metallschicht eine Silberschicht ist, die gemäß dem Silbersalz-Diffusionsübertragungsverfahren aus einem fotografischen Silberhalogenidmaterial erhalten ist.

2. Ein wärmeempfindliches Aufzeichnungsmaterial nach Anspruch 1, dadurch gekennzeichnet, daß die Stärke der Metallschicht zwischen 0,05 µm und 1,5 µm liegt.

3. Ein wärmeempfindliches Aufzeichnungsmaterial nach Anspruch 1, dadurch gekennzeichnet, daß die auf der Metallschicht befindliche hydrophile Schicht ein Hydrophiliermittel entsprechend der Formel
MS-R-A (I)
in der M Wasserstoff, ein Metallkation oder NH4+, R eine zweiwertige Verbindungsgruppe und A eine hydrophile Gruppe bedeutet, enthält.

4. Ein wärmeempfindliches Aufzeichnungsmaterial nach Anspruch 3, dadurch gekennzeichnet, daß die zweiwertige Verbindungsgruppe eine nicht-substituierte niedrigere Alkylengruppe (C₁-C₄-Gruppe), eine nicht-substituierte Phenylengruppe, eine Oxyalkylengruppe, eine Polyoxyalkylengruppe, eine mit einer oder mehreren hydrophilen Gruppen substituierte Alkylengruppe, eine mit einer oder mehreren hydrophilen Gruppen substituierte Arylengruppe, eine mit einer oder mehreren hydrophilen Gruppen substituierte Arylenalkylengruppe, eine mit einer oder mehreren hydrophilen Gruppen substituierte Alkylenarylengruppe oder ein substituierter oder nicht-substituierter heterocyclischer Ring ist.

5. Ein wärmeempfindliches Aufzeichnungsmaterial nach irgendeinem der vorstehenden Ansprüche, das auf der hydrophilen Schicht mit einer Stärke von weniger als 50 nm weiterhin eine hydrophile polymere Schicht enthält.

6. Ein Verfahren zur Erzeugung einer lithografischen Druckplatte, in dem ein in irgendeinem der vorstehenden Ansprüche definiertes wärmeempfindliches Aufzeichnungsmaterial bildmäßig mit aktinischer Strahlung belichtet wird, wobei die belichteten Bereiche hydrophob und fette Farbe anziehend gemacht werden.

7. Ein Verfahren nach Anspruch 6, dadurch gekennzeichnet, daß die bildmäßige Belichtung mit einem Laser durchgeführt wird.

## Revendications

1. Un matériau d'enregistrement thermique comprenant sur un support une couche métallique et là-dessus une couche hydrophile ayant une épaisseur de moins de 50 nm, caractérisé en ce que la couche métallique est une couche d'argent provenant d'un matériau photographique à l'halogénure d'argent selon le procédé de transfert de sel d'argent par diffusion.

2. Un matériau d'enregistrement thermique selon la revendication 1, caractérisé en ce que l'épaisseur de cette couche métallique se situe entre 0,05 µm et 1,5 µm.

3. Un matériau d'enregistrement thermique selon la revendication 1, caractérisé en ce que la couche hydrophile sur la couche métallique contenant un agent hydrophilisant correspondant à la formule suivante:
MS-R-A
dans laquelle
M représente de l'hydrogène, un cation métallique ou NH4+;
R représente un groupe de liaison bivalent et
A représente un groupe hydrophile

4. Un matériau d'enregistrement thermique selon la revendication 3, caractérisé en ce que le groupe de liaison bivalent est un alkylène (C1-C4) inférieur non substitué, un phénylène non substitué, un oxyalkylène, un polyoxyalkylène, un alkylène substitué par un ou plusieurs groupes hydrophiles, un arylène substitué par un ou plusieurs groupes hydrophiles, un arylènealkylène substitué par un ou plusieurs groupes hydrophiles, un alkylènearylène substitué par un ou plusieurs groupes hydrophiles ou un noyau hétérocyclique substitué ou non substitué.

5. Un matériau d'enregistrement thermique selon l'une quelconque des revendications précédentes, comprenant en plus une couche hydrophile polymère sur la couche hydrophile ayant une épaisseur de moins de 50 nm.

6. Un procédé pour faire une plaque d'impression lithographique comprenant l'exposition sous forme d'image à un rayonnement actinique d'un matériau d'enregistrement thermique tel que défini dans l'une quelconque des revendications précédentes, grâce à quoi les zones exposées sont rendues oléophiles et acceptent de l'encre grasse.

7. Un procédé selon la revendication 6, caractérisé en ce que l'exposition sous forme d'image est effectuée par un laser.
